# EUROPEAN PATENT APPLICATION

(11) **EP 2 343 564 A1**
(43) Date of publication of application: **13.07.2011**
(21) Application number: 09290989.4
(22) Date of filing: 23.12.2009
(51) Int. Cl.: G01R 31/3187

(54) **Built-in chip self-test apparatus and method**

(71) Applicant: NXP B.V., 5656 AG Eindhoven (NL)
(72) Inventor: Lefevre, François, 5656 AE Eindhoven (NL)
(74) Representative: Krott, Michel

(57) **Abstract**

The present invention relates to a chip self-test apparatus at least partially embedded in an integrated circuit, and to a method of testing an integrated circuit, wherein test functionalities are embedded inside the integrated circuit, so that testing and sorting of integrated circuits is allowed without complex industrial testers. Integrated tests can be made faster than external tester instruments, and more devices can be tested in parallel, leading to more test efficiency.
The chip self-test apparatus of the present invention comprises a secondary oscillator, for providing a test signal at an input of the integrated circuit, a power sensor, for measuring the test signal at an output of the integrated circuit, and a control circuit, for controlling the secondary oscillator and the power sensor.

## Description

### FIELD OF THE INVENTION

The present invention relates to chip self-test apparatus, chip testing system, and method of testing an integrated circuit, such as a radio frequency (RF) integrated circuit (IC).

### BACKGROUND OF THE INVENTION

Increasingly, state of the art semi-conductor integrated circuit manufacturing techniques make it possible to produce ICs with integrated capability of handling radio frequency (RF) signals. "RF", as used herein, refers to signals with frequencies used for wireless transmission.

The main tests of RF circuits involve the application to the circuit of RF signals at frequencies that will be used during normal operation of the circuit, or measurement of such signals after their generation by the circuit. On the other hand, logic functions of integrated circuits are generally tested by applying logic test patterns and observing test responses at much lower frequencies. Test equipment for the latter type of test is generally standard in most IC manufacturing facilities and is applied to almost all more complex digital integrated circuits. On the other hand, equipment for RF testing is not widely available and applies additional investment if integrated circuits with RF circuits have to be manufactured and tested.

The US 2007/033474A1 discloses a production test technique for RF circuits using embedded test sensors, wherein an external RF source, a sensor and some signal processing modules are used. Hence, the proposed system requires a long and complex learning phase with non-linear regression models to predict test results. Additionally, the WO 2006/103617A1 discloses a test-prepared RF integrated circuit, wherein an RF circuit is tested with test frequencies lower than those used in the normal application. A frequency divider is added between a local oscillator and a mixer for test purposes.

Semi-conductor manufacturers need to provide high levels of quality at low cost. In order to improve margins, it is essential to decrease test production costs and simplify test procedures and test equipment. In case of complex RF devices like silicon tuners, a lot of time-consuming RF tests should be performed to check the specification and functionality of the device. This leads to long test times and therefore high production costs. Also, the possibility of testing several devices in parallel at the same time (so called "multi-site") may be limited by the number of resources of the test equipment. The multi-site technique helps to reduce the test time per device under test (DUT) but needs complex test equipment with many resources. Moreover, complex RF products require expensive RF resources (source and measure units) to execute a test list compatible with customer quality needs. Low cost direct current (DC) test equipments cannot be used for such products.

In summary, testing of complex RF ICs involves problems concerning the time it takes to perform RF tests, the fact that testing several devices in parallel is limited by the number of RF resources of the test equipment, and the impossibility to transfer the test process to less complex DC test equipments.

### SUMMARY OF THE INVENTION

It is an object of the present invention to provide an improved test apparatus, system, and method which reduces complexity of the test equipment for RF ICs.

In a first aspect of the present invention a chip self-test apparatus at least partially embedded in an integrated circuit is presented, which comprises:
- a secondary oscillator integrated in said integrated circuit and providing a test signal at an input of said integrated circuit;
- a power sensor integrated in said integrated circuit and adapted to measure said test signal at an output of said integrated circuit; and
- a control circuit adapted to control said secondary oscillator and said power sensor based on a test sequence.

In a further aspect of the present invention a method of testing an integrated circuit is presented, which comprises:
- controlling a secondary oscillator integrated in said integrated circuit to provide a test signal;
- triggering on said integrated circuit a power sensor measurement by a power sensor integrated in said integrated circuit;
- waiting for a predetermined time or for an end-of-measurement signal from said power sensor; and
- reading a measured value from said power sensor.

Accordingly, the above problem can be solved by implementing proper design features inside the integrated circuit. These design features may already be part of the IC architecture for application purposes, so that the required added design task is limited. In case they would not be part of a product for whatever reason, it is also possible to add them for test purpose.

In order to reduce complexity of test equipment, it is proposed to use the secondary generator and the power sensor, which may be provided already in the integrated circuit. Indeed, a secondary generator is usually provided for generating an RF signal for calibration purposes and may replace an RF test signal needed at the RF input of the product. Instead of using industrial tester RF sources, an internal RF signal can be used to stimulate the front-end parts of the integrated circuit. Similarly, an incorporated power sensor can be used for measurements to perform output signal tests instead of using the tester measurement resources. Thus, a low cost DC tester may be used, as no RF resources are needed anymore.

The fact that the test resources are embedded inside the device under test leads to the advantage that several devices can be tested in parallel, because only largely available DC resources are needed. For instance, testing 4 or 8 devices at the same time is possible by the embedded solution. Furthermore, using the resources embedded in the integrated circuit enables faster testing procedures. Thus, the design features proposed in the present invention allow testing devices even faster.

Unlike the prior art systems, an external RF source is no longer required to generate a complex stimulus. The fact that no RF instrument (source and measure) is needed is a true enabler for production on a less complex test equipment. Moreover, the invention necessitates only a single pin or a simple bus to control the integrated circuit and to perform the test sequence. The proposed solution also allows sorting more devices at the same time in parallel, thus further reducing production test time and cost. Direct measurement results are provided and long and complex learning phases are no longer necessary. So, once the integrated circuit is designed, it is immediately applicable. Its simplicity makes it easy to design and does not need a complex digital signal processor.

As an additional advantage, the device can be tested at normal operating frequencies instead of much lower frequencies. Therefore, the device is checked as it is used in the customer application, and this helps capturing all errors and faults, especially as the RF performances of the device are more difficult to reach at high frequency. Moreover, the frequency range of the test setup is the same as in the customer application, and will therefore work fine during test sequence. On the other hand, the above prior art system may not work in some cases because of the very low frequency needed and the high pass filtering effect of some blocks, which are not compatible. The present solution does not require an external source to generate a signal at the input of the device under test.

The secondary oscillator and the power sensor may be adapted to be operable for test purposes and for application purposes of the integrated circuit. Thereby, additional components are not longer required for industrial test purposes, since those for customer application purposes can be used for both purposes.

Moreover, at least one of the secondary oscillator and the power sensor may be adapted to be separable from application components of the integrated circuit. Hence, the test functions can share the same design blocks as the application functions and can be separated e.g. by switching elements for example. Additionally, the secondary oscillator may be adapted to generate the test signal for test purposes and to be used for internal calibration for application purposes. This provides the advantage that no additional secondary oscillator is necessary since the one for internal calibration can be used as well for the test signal.

The output of the secondary oscillator may be switchably connected to the input of the integrated circuit during the test sequence only. Similarly, the power sensor may be adapted to measure the test signal during the test sequence only. Consequently, the power sensor can be embedded inside the integrated circuit in order to replace any external measurement equipment used for industrial test purposes.

As an additional option, the power sensor can be internally switchably connected to the output.

The control circuit may be integrated in the integrated circuit and adapted to be operable as an interface between at least one of the reference oscillator and the power sensor on one side, and an external test equipment on the other side. Thereby, the control circuit works as an interface between the internal test functionalities and an external industrial tester.

The test sequence may comprise a list of test processes for evaluating performance of said integrated circuit. The test sequence can be embedded inside the integrated circuit as a true built-in-self-test or can be implemented within the industrial test program of the tester.

The control circuit may be adapted to be shared within an integrated circuit control entity for application purposes of the integrated circuit.

Additionally, the control circuit may be connectable to an external test equipment via at least one of a single pin, a bus, and a scan test protocol. This enables parallel testing of several integrated circuits with the external test equipment via the dedicated individual control circuits.

According to a further option, at least one of a first attenuator provided at the output of the secondary oscillator and a second attenuator provided at the input of the power sensor may be incorporated. Such attenuators allow changing the test signal level, while the characteristics of the attenuation (such as value, number of steps, continuous or discrete) may depend on the test sequence needs and on the test specification of each tested block.

The above method may be implemented as a computer program product comprising code means for carrying out the method steps when run on a computing device. The computer program product may be stored/distributed on a suitable medium, such as an optical storage medium or a solid-state medium supplied together with or as part of other hardware, but may also be distributed in other forms, such as via the Internet or other wired or wireless telecommunication systems.

Preferred embodiments of the invention are defined in the dependent claims. It shall be understood that the chip self-test apparatus of claim 1 and the method of claim 15 have similar and/or identical preferred embodiments as defined in the dependent claims.

### DETAILED DESCRIPTION OF THE INVENTION

The present invention is further elucidated by the following figures and examples, which are not intended to limit the scope of the invention. The person skilled in the art will understand that various embodiments may be combined.

### BRIEF DESCRIPTION OF THE DRAWINGS

These and other aspects of the invention will be apparent from and elucidated with reference to the embodiment(s) described hereinafter. In the following drawings
Fig. 1 shows a schematic block diagram of an integrated circuit under test;
Fig. 2 shows a conventional industrial test setup to check an integrated circuit with a conventional method;
Fig. 3 shows a schematic block diagram of a test apparatus embedded in an integrated circuit, according to the present invention;
Fig. 4 shows a test setup with a test apparatus according to the present invention;
Fig. 5 shows a test setup to measure several devices in parallel according to the present invention; and
Fig. 6 shows a method for testing an integrated circuit according to the present invention.

### DETAILED DESCRIPTION OF THE DRAWINGS

In the following, embodiments of the present invention are described in greater detail based on a simplified test setup with embedded test functionalities.

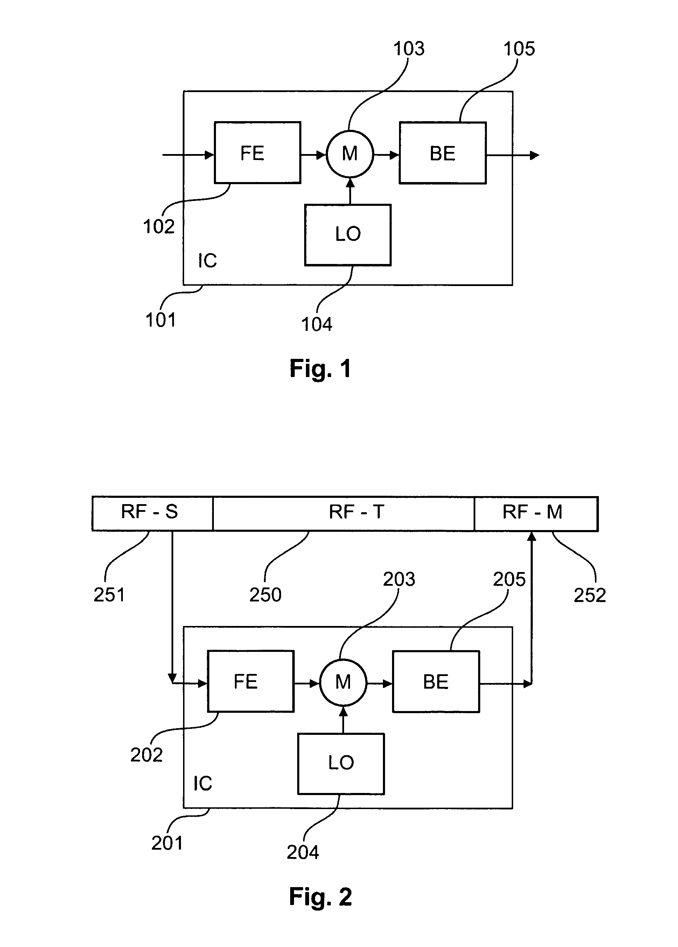

The preferred embodiments are described on the basis of an integrated circuit such as a silicon tuner as depicted in Fig. 1.

Fig. 1 shows a schematic block diagram of a silicon tuner comprising an integrated circuit 101 which indicates a front-end unit or block (FE) 102, a mixer (M) 103, a local oscillator (LO) 104, and a back-end unit or block (BE) 105. The front-end block 102 can be connected to an antenna or cable connector and may contain a low noise amplifier for amplifying the received signal, some RF filters and an automatic gain control functionality. The local oscillator 104 is adapted to produce a frequency near to a desired channel by means of e.g. a phase locked loop synthesizer or any other controlled oscillator circuit. The output signal of the front-end block 102 and the oscillation signal of the local oscillator 104 are mixed in the mixer 103 based on its mixing characteristic to deliver a low frequency signal going through the back-end block 105 where it may be filtered and amplified as needed. The output of the back-end block 105 can be connected to a channel decoder or demodulator for decoding or demodulating the received and down converted signal, respectively.

The integrated circuit shown in Fig. 1 is a silicon tuner, which means it is intended for reception of a signal. But of course, it is also possible to use the proposed solution and adapting the present invention for any other device similar to the one described here, for example a transmitter integrated circuit. In that case, the back-end block 105 is operated at a higher frequency than the front-end block 102, wherein the mixer 103 is used for up conversion. In this usage or application of the integrated circuit, the back-end block 105 may contain an amplifier and some band pass filters. Thus, the present invention can be used both for a receiver integrated circuit or a transmitter integrated circuit or any other similar device, whether they are designed separately or together on the same semi-conductor or crystal or in the same package.

Fig. 2 shows a schematic block diagram of a conventional test setup for checking a silicon tuner or other type of semi-conductor device. A production RF tester (RF-T) 250 is arranged to provide an RF source (RF-S) 251 for generating a test signal, and an RF measure or measuring part (RF-M) 252 for sensing or measuring an output signal of a back-end block (BE) 205 which receives an output signal of a mixer (M) 203 generated by mixing the output signal of a front-end block (FE) 202 and of a local oscillator (LO) 204 of the test integrated circuit 201. As can be gathered from Fig. 2, the conventional test setup provides the disadvantage that an expensive RF tester is required and that only one integrated circuit can be tested at a time with a single RF tester.

In order to get rid of a complex RF tester and provide a simple low frequency and low cost tester, it is suggested in the following preferred embodiments to implement at least some of the test functionalities in the integrated circuit.

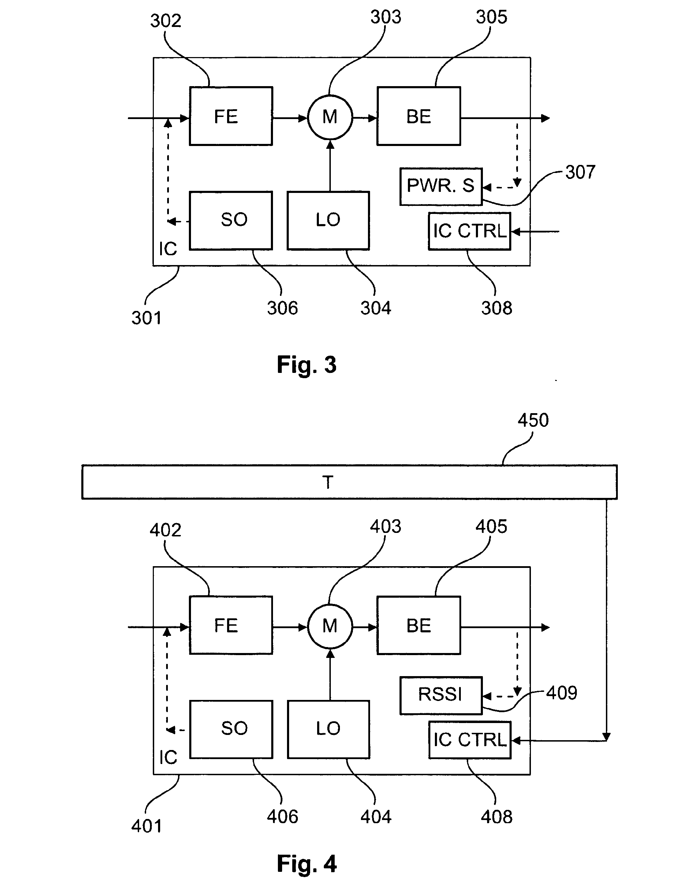

Fig. 3 shows a schematic block diagram of an integrated circuit (e.g. a silicon tuner) with embedded test resources or functionalities enabling use of a simplified test equipment. Besides the known blocks or entities front-end block (FE) 302, mixer (M) 303, back-end block (BE) 305, and local oscillator (LO) 304 three additional units or blocks are embedded in the integrated circuit 301. At least some of these new blocks may be already provided in the integrated circuit 301 for customer application purposes. This provides the advantage that additional chip or silicon area for implementing the proposed solution is negligible. Thus, the three new blocks may be specific for test purposes or may be used for both application and test purposes.

The first added block is a secondary oscillator (SO) 306 which generates the test signal so far provided by the complex external RF tester. The secondary oscillator 306 is adapted to generate a signal in the same frequency range as expected at the RF input of the integrated circuit 301. It may be any type of oscillator circuit (e.g. phase locked loop (PLL) oscillator, amplifier with negative feedback, etc.). The level of the test signal may be fixed to a specific value, which makes the design of the secondary oscillator 306 easier. In that case, the fixed output level of the secondary oscillator 306 can be set to a value which enables proper testing of the RF chain, consisting of the front-end block 302, the mixer 303, and the back-end block 305. The value of the test signal can be calculated so that the signal level remains within a dynamic range of all blocks through which it passes. If the signal level is too low, then the measurement of the test signal may not be possible due to the fact that the measurement instrument may not discriminate the signal from the noise provided at the output of the back-end block 305. On the other hand, if the signal level value is too high, then the measurement may be wrong because of saturation effects appearing along the RF signal path. Thus, the signal level value should be set appropriately by taking into account the attenuation and amplification along the signal path between the output of the secondary oscillator 306 and the signal level measurement block. The dynamic level range of the measurement block may also be included in the calculation.

However, in specific cases it may not be possible to find a single fixed value of the test signal compatible with all test needs. Reason for this may be that the dynamic level range of the measurement block is not sufficient or that some blocks along the RF path require an excessive dynamic range. This problem can be solved by providing two or more fixed level values calculated as explained above. For instance, a switched attenuator may be inserted in the output path of the secondary oscillator 306 to deliver two or more fixed RF levels. Then, testing can be performed even if the dynamic level range of some blocks is very demanding. Of course, also a continuously adjustable level can be used, if needed.

In the preferred embodiment, the secondary oscillator 306 may be adapted to provide a sine wave signal. Using such a simple signal makes the second oscillator 306 easier to design and allows covering most of the test needs. However, any other kind of signal may be used as well.

The design of the secondary oscillator 306 may depend on the final functionality of the integrated circuit 301. It may be designed similar to the local oscillator 304 or it may as well be possible to shift the frequency of the local oscillator 304 by using a mixer to generate the wanted test signal.

The secondary oscillator 306 can be controlled by a control block (IC CTRL) 308 provided in the integrated circuit 301. This control block 308 can be adapted to control the frequency of the secondary oscillator 306 as needed, and the level of the oscillation signal in case several levels may be programmed. The control block 308 may also manage the connection of the output of the secondary oscillator 306 to the RF input of the integrated circuit 301. During customer use of the integrated circuit 301, the output of the secondary oscillator 306 can be separated from the RF input of the integrated circuit 301. Thus, during production testing, the control block 308 connects the output of the secondary oscillator 306 to the input of the front-end block 302.

The new second block is a power sensor (PWR. S). The purpose of this block is to replace the measurement resource (e.g. RF measure 252) of the complex conventional RF tester 250 depicted in Fig. 2. The power sensor block 307 may be designed for customer application purposes, as well, in order to measure received or transmitted channel signals. It may also be designed for test purposes only or for both application and test purposes. In case it is already provided in the integrated circuit 301 for customer needs, the additional silicon area related to the present embodiment is again negligible.

The power sensor block 307 may be connected to the output of the back-end block 305. This connection may be permanent or only during test usage, which depends on e.g. customer application needs.

The power sensor block 307 may be designed to measure a signal in the same ranges as expected at the output of the integrated circuit 301. As explained above concerning the secondary oscillator 306, the dynamic level range of the power sensor block 307 can be calculated and designed to fit with the dynamic level range of the output signal to be measured. In case it does not fit, some additional functionalities or features could be added. For instance, one (or several) attenuator(s) may be provided to avoid saturation at the input of the power sensor block 307 by reducing the amplitude of the signal to be measured.

The power sensor block 307 can be designed to provide a measurement of the amplitude of the output signal of the integrated circuit 301. Therefore, a simple detector may be sufficient to evaluate the amplitude of the signal at the output of the back-end block 305. In most cases, a detector with an analog-to-digital converter (ADC) can be used to provide the amplitude measurement to the control block 308, which should be able to start a measurement and read back the results from the power sensor 307 at any time during the test sequence. A proper synchronization between the power sensor block 307 and the control block 308 allows optimized measurement duration. Depending on the required accuracy, an averaging feature may be implemented at the power sensor block 307 to average the measurement results over several measurements. This feature can be set to a fixed averaging count or can be programmable as required by the user of the embodiment.

The third block is the control block 308 which may be any kind of processor or processing circuit adapted to control application or test procedures in the integrated circuit 301 e.g. based on a corresponding software routine or based on hard-wired functionalities. The integrated circuit 301 may already contain such a control block as an interface between a customer application and other blocks of the integrated circuit 301. In the customer application, the integrated circuit 301 may exchange control messages with for instance a microprocessor or other master integrated circuits. The messages can be sent through a control bus (not shown) such as an I²C bus or a three wire bus or the like. The control block 308 may then receive some orders to control the blocks of the integrated circuit 301. It may also send messages describing the status of these blocks using communication modes provided in the customer application.

In the preferred embodiment, the same control block 308 may also be used for test purposes. However, as an alternative option, it is of course also possible to add a separate control block for test purposes only, so that two different control blocks are provided, one for application purposes and one for test purposes.

The test function of the control block 308 provides control over at least one of the two other blocks i.e. secondary oscillator 306 and power sensor block 307.

Fig. 4 shows a schematic block diagram of a test setup architecture with embedded test resources according to the preferred embodiment. Again, an integrated circuit 401 to be tested comprises a front-end block (FE) 402, a mixer (M) 403, a back-end block (BE) 405 and a local oscillator (LO) 404 as described in the above Figs. 1 to 3. Additionally, the two new blocks secondary oscillator (SO) 406 and control block (IC CTRL) 408 are provided. Here, the power sensor block 409 is arranged as a sensor for measuring the received signal strength indicator (RSSI) which is used as an estimator for link quality. Of course, other indicators such as a for example a link quality indicator (LQI) could be used as well for power sensor measurement.

In the proposed test setup architecture, the control block 408 can be connected to a microprocessor or a master integrated circuit in the customer application (not shown and external to the integrated circuit 401). As shown on Fig. 4, during the test operations, the control block 408 is connected to an industrial tester 450 by means of a bus, which may be an I²C bus, a three wires bus or even based on a scan test protocol or any other way of connection as desired.

Depending on the level of integration, the connection may however differ. If the test sequence protocol is fully integrated inside the integrated circuit 401, then the control may be very simple and can be limited to a single direct current (DC) pin. For instance, when the industrial tester 450 provides a trigger signal (e.g. pulls down the voltage of the pin), the test starts, while the integrated circuit 401 may pull up the voltage to different values to indicate a pass or fail test result. Of course any other way of binary or non-binary trigger signaling can be used as well. On the other hand, in case the test sequence is not integrated inside the integrated circuit 401, then the control may be more complex, because the industrial tester 450 may be adapted to program all blocks of the integrated circuit 401 with proper settings and read back the measurement results to take the pass/fail decision for the integrated circuit 401 under test. Thus, in such cases, the same communication bus as used in the customer application may be used for test purposes. Another possibility would be to use scan test pins.

In the preferred embodiment, the industrial test sequence to test and sort the integrated circuit 401 may be fully integrated inside the integrated circuit 401 by the designer, for example in the control block 408 as a software routine or hardwire application (e.g. state machine). Then, the industrial tester 450 only triggers the integrated circuit 401 to start the test sequence, and then once the integrated circuit 401 has finished its built-in-self-test procedure, it returns a pass/fail flag or information to the industrial tester (T) 450. In this implementation, only very limited resources are required at the industrial tester 450, leading to less complexity and less costs of production.

In case the industrial test sequence is not integrated inside the integrated circuit 401, it is still possible to benefit from the advantages of the present invention without departing from it. This choice allows reducing the design task and still permits usage of an industrial tester 450 with lower complexity. Instead of implementing the test sequence in the integrated circuit design with a state machine, it could be implemented in the code of a test program managing the industrial tester 450, thus providing more flexibility for any future change, than when the test sequence is integrated inside the integrated circuit 401.

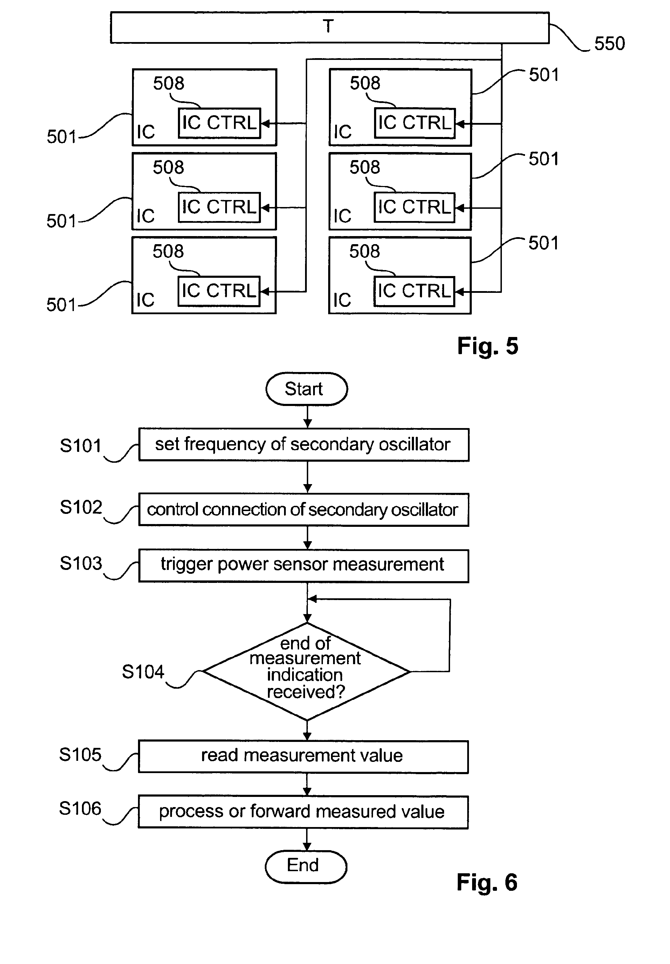

Fig. 5 shows a schematic block diagram of a test setup architecture adapted to measure several devices in parallel by using an industrial tester (T) 550 with low complexity, so that if a test efficiency can be further increased. The preferred embodiment of Fig. 5 permits testing several integrated circuits 501 at the same time without the need for a more expensive industrial tester 550 equipped with many resources. Each of the integrated circuits 501 under test includes a control block (IC CTRL) 508 as described above in connection with Figs. 3 and 4. The industrial tester 550 is connected to these several integrated circuits 501, so that for instance six integrated circuits 501 can be tested in parallel at the same time. They can be connected by individual buses or control lines so as to be tested and controlled in parallel.

Fig. 6 shows a schematic flow diagram of a test procedure which may be implemented at the control blocks 308, 408, and 508, respectively or at the industrial tester 450 or 550, respectively.

According to Fig. 6, the secondary oscillator 306 may be controlled in the same way as the main local oscillator 304, 404, respectively. In step S101, the frequency of the secondary oscillator 306 is set to any value as wanted for the test needs and preferably in the same range as required at the input of the integrated circuit 301, 401 or 501, respectively. More specifically, the frequency of the two oscillators (local oscillator and secondary oscillator) can be programmed independently in order to be able to get any frequency after the mixer 303 or 403, respectively. This allows testing the back-end block 305 or 405, respectively, properly. In step S102, the test procedure (which controls the control block 308 or 408 or 508, respectively) manages the connection of the secondary oscillator 306 to the input of the front-end block 302 or 402, respectively. A switch may be used to select whether the input of the integrated circuit 301, 401 or 501, respectively, or the secondary oscillator 306 or 406, respectively, functions as the input for the front-end block 302 or 402, respectively.

Then, in step S103 the test procedure controls the power sensor block 307 or 409, respectively, to trigger the start of the power sensor measurement. Then, the control block 301, 401 or 501, respectively waits in step S104 for a predefined time or for an end-of-measurement signal from the power sensor block 307 or 409, respectively, in order to make sure that the power sensor measurement is correctly finished. Next, in step S105, the control block reads the measurement value from the power sensor block. Finally, in step S106, the result may be processed internally inside the control block or may be sent to the industrial tester for external calculation and pass/fail decision.

In summary, a chip self-test apparatus at least partially embedded in an integrated circuit, and to a method of testing an integrated circuit have been described, wherein test functionalities are embedded inside the integrated circuit, so that testing and sorting of integrated circuits is allowed without complex industrial testers. Integrated tests can be made faster than external tester instruments, and more devices can be tested in parallel, leading to more test efficiency.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single item or other unit may fulfill the functions of several items recited in the claims. The mere fact that certain measures are recited in mutually different dependent claims does not indicate that a combination of these measures cannot be used to advantage.

Any reference signs in the claims should not be construed as limiting the scope.

## Claims

1. A chip self-test apparatus at least partially embedded in an integrated circuit, comprising:
- a secondary oscillator (306; 406) integrated in said integrated circuit and providing a test signal at an input of said integrated circuit;
- a power sensor (307; 409) integrated in said integrated circuit and adapted to measure said test signal at an output of said integrated circuit; and
- a control circuit (308; 408; 508) adapted to control said secondary oscillator and said power sensor based on a test sequence.

2. The apparatus according to claim 1, wherein said secondary oscillator (306; 406) and said power sensor (307; 409) are adapted to be operable for test purposes and for application purposes of said integrated circuit.

3. The apparatus according to claim 2, wherein at least one of said secondary oscillator (306; 406) and said power sensor (307; 409) are adapted to be separable from application components of said integrated circuit.

4. The apparatus according to any one of the preceding claims, wherein said secondary oscillator (306; 406) is adapted to generate said test signal for test purposes and to be used for internal calibration for application purposes.

5. The apparatus according to any one of the preceding claims, wherein an output of said secondary oscillator (306; 406) is switchably connected to said input during said test sequence only.

6. The apparatus according to any one of the preceding claims, wherein said power sensor (307; 409) is adapted to measure said test signal during said test sequence only.

7. The apparatus according to any one of the preceding claims, wherein said power sensor (307; 407) is internally switchably connected to said output.

8. The apparatus according to any one of the preceding claims, wherein said integrated circuit is a radio frequency tuner or receiver circuit, or a transmitter.

9. The apparatus according to any one of the preceding claims, wherein said control circuit (308; 408; 508) is integrated in said integrated circuit and adapted to be operable as an interface between at least one of said reference oscillator (306; 406) and said power sensor (307; 409) on one side, and an external test equipment (450; 550) on the other side.

10. The apparatus according to any one of the preceding claims, wherein said test sequence comprises a list of test processes for evaluating performance of said integrated circuit.

11. The apparatus according to any one of the preceding claims, wherein said control circuit (308; 408; 508) is adapted to be shared with an integrated circuit control entity for application purposes of said integrated circuit.

12. The apparatus according to any one of the preceding claims, wherein said control circuit (308; 408; 508) is connectable to an external test equipment via at least one of a single pin, a bus, and a scan test protocol.

13. The apparatus according to any one of the preceding claims, further comprising at least one of a first attenuator provided at the output of said secondary oscillator (306; 406), and a second attenuator provided at the input of said power sensor (307; 409).

14. A chip testing system comprising a test equipment (450; 550) connectable to a plurality of chip self-test apparatuses according to claim 1.

15. A method of testing an integrated circuit, said method comprising:
- controlling a secondary oscillator (306; 406) integrated in said integrated circuit to provide a test signal;
- triggering on said integrated circuit a power sensor measurement by a power sensor (307; 409) integrated in said integrated circuit;
- waiting for a predetermined time or for an end-of-measurement signal from said power sensor (307; 409); and
- reading a measured value from said power sensor (307; 409).

16. A computer program product comprising code means for carrying out the steps of method claim 15 when run on a computing device.

17. A state machine comprising instructions for carrying out the steps of method claim 15 when integrated inside an integrated circuit.
